# EUROPEAN PATENT APPLICATION

(11) **EP 3 419 155 A1**
(43) Date of publication of application: **26.12.2018**
(21) Application number: 17177365.8
(22) Date of filing: 22.06.2017
(51) Int. Cl.: H02M 1/44, H05K 9/00, H05K 1/02, H02M 3/335

(54) **POWER CONVERTER WITH INSULATING MATERIAL**

(71) Applicant: NPC Tech ApS, 2730 Herlev (DK)
(72) Inventor: MADSEN, Mickey P., 2730 Herlev (DK); ANDERSEN, Thomas, 2500 Valby (DK); RØDGAARD, Martin Schøler, 2800 Kgs. Lyngby (DE); MØNSTER, Jakob Døllner, 2200 Copenhagen N (DE); ANDERSEN, Toke Meyer, 2400 Copenhagen NV (DE)
(74) Representative: Guardian IP Consulting I/S

(57) **Abstract**

A power converter comprising a housing for accommodation of an electrical circuit assembly that is adapted for converting an input voltage to an output voltage, a first mechanical assembly that is mounted to the electrical circuit assembly for suppression of electromagnetic radiation emitted by the electrical circuit assembly, and an insulating material interposed between first and second conductors of the electrical circuit assembly for reducing required distances between respective first and second conductors for proper operation of the electrical circuit assembly.

## Description

### FIELD

A new power converter with a mechanical assembly for suppression of electromagnetic interference is provided.

### BACKGROUND

LED lighting applications and point-of-load (PoL) power converters particularly benefit from very high frequency (VHF) converters due to size, price, weight reduction, and faster transient response.

Typically, power converters include electromagnetic metal shields for fulfilling electromagnetic compatibility (EMC) requirements. The electromagnetic metal shields are used to suppress emission of electromagnetic radiation from the power converters.

For power converters supplied from the mains supply, incorporation of an electromagnetic metal shield leads to a larger power converter due to clearance and creepage distance requirements set by electronic circuit design rules.

The electromagnetic metal shield typically has a relatively large surface area that is connected to ground either at a primary, i.e. input, side or a secondary, i.e. output, side of the power converter. Conductors connected to the opposite side of the power converter have to be kept at least the required design distance, e.g. clearance or creepage distance of typically ranging from 5 mm to 8 mm, from the surface of the electromagnetic metal shield. Thus, presence of the electromagnetic metal shield creates a large volume of the power converter that cannot accommodate conductors that are connected to the opposite side of the power converter.

Standards specifying requirements for clearance and creepage distances include IEC 61347-1 for lamp control gear and IEC 60664-1 for insulation coordination for equipment within low-voltage systems.

### SUMMARY

A new power converter is provided, having
an electrical circuit assembly,
a first mechanical assembly for suppression of electromagnetic interference, i.e. electromagnetic radiation emitted by the electrical circuit assembly and/or electromagnetic radiation received by the electrical circuit assembly, and
an insulating material, such as a potting material, etc., between first and second conductors of the power converter, e.g. of the electrical circuit assembly and the first mechanical assembly, respectively, for reducing required clearance and creepage distances between respective first and second conductors.

The power converter may be a switched mode power supply, a HF power converter, a VHF power converter, etc.

The power converter has an input and an output.

The power converter may be adapted for converting an input voltage supplied to the input of the power converter into an output voltage and current provided by the output of the power converter.

The power converter may be adapted for converting an input current supplied to the input of the power converter into an output voltage and current provided by the output of the power converter.

The power converter may have a housing for accommodation of the electrical circuit assembly, the first mechanical assembly, and the insulating material.

The electrical circuit assembly may comprise a conventional printed circuit board (PCB) with mounted circuit components, including, e.g., surface mounted components, integrated circuits, semiconductors, inductors, transformers, capacitors, resistors, connectors, etc.

The first mechanical assembly may be made of metal or metal-alloy or another material that prevents or suppresses propagation of electromagnetic radiation through the first mechanical assembly.

The first mechanical assembly may be shaped as a rectangular box, e.g. formed by one or more sheets of the material. The first mechanical assembly may alternatively have a more complex shape and may include a plurality of parts that may be connected to different parts of the electrical circuit assembly.

In the power converter, the input may be galvanically separated from the output.

In the power converter, a selected first part of the electrical circuit assembly may be covered with or embedded in the insulating material and a selected second part of the electrical circuit assembly may not be covered by or embedded in the insulating material.

The first part of the electrical circuit assembly may include a part of the electrical circuit assembly covered by the first mechanical assembly.

The second part of the electrical circuit assembly may include the remaining part of the electrical circuit assembly.

In some power converters, all parts of the electrical circuit assembly except connectors may be covered by the insulating material.

The power converter may have an operating frequency above 5 MHz.

The electrical circuit assembly may have a primary side connected to the input and a secondary side connected to the output.

The power converter may comprise a second mechanical assembly that is mounted to the electrical circuit assembly for suppression of electromagnetic interference, i.e. electromagnetic radiation emitted by a part of the electrical circuit assembly and/or electromagnetic radiation received by a part of the electrical circuit assembly.

The second mechanical assembly may be made of metal or metal-alloy or another material that prevents or suppresses propagation of electromagnetic radiation through the second mechanical assembly.

The second mechanical assembly may be shaped as a rectangular box, e.g. formed by one or more sheets of the material. The second mechanical assembly may alternatively have a more complex shape and may include a plurality of parts that may be connected to different parts of the electrical circuit assembly.

A space formed between the first mechanical assembly and the second mechanical assembly may accommodate part of the insulating material.

The first mechanical assembly may be mounted to the electrical circuit assembly on one component side of a printed circuit board of the electrical circuit assembly and the second mechanical assembly may be mounted to the opposite component side of the printed circuit board.

At least one of the first mechanical assembly and the second mechanical assembly may be connected to a voltage potential with a reference to the primary side or the secondary side.

At least one of the first mechanical assembly and the second mechanical assembly may be connected to a zero-voltage reference potential of the primary side or the secondary side.

The first and/or the second mechanical assembly may have a plurality of holes, e.g. to allow air to pass through the mechanical assembly during insulating and/or to allow the insulating material to enter into the mechanical assembly in question.

At least one of the first and second mechanical structures may be connected to a conductor, e.g. a ground plane, of a printed circuit board of the electrical circuit assembly, in such a way that the interconnected at least one of the first and second mechanical structures forms an enclosure for suppression of electromagnetic interference, e.g. by suppression of electromagnetic radiation emitted by the electrical circuit assembly and/or by suppression of electromagnetic radiation received by the electrical circuit assembly.

The power converter may further comprise one or more heat sinks mounted to the first and/or the second mechanical assembly for improved heat dissipation.

The insulating material has a high dielectric strength that is at least higher than the dielectric strength of air to provide improved insulation of conducting surfaces as desired to reduce clearance and creepage distance requirements.

Preferably, the insulating material also has good thermal conductivity so that the insulating material is capable of transmitting heat generated by components covered by or embedded in the insulating material away from the heat generating components.

The insulating material can be a gas, a liquid, or preferably, a solid material.

The insulating material may comprise thin sheets of the material.

Preferably, the insulating materials have a low glass transition temperature T_{g}, which is the temperature at which the insulating material changes structure, similar to a crystalline structure change, and becomes harder and more brittle. For example, urethane and silicone based insulating materials are preferred in order to avoid breaking of solder connections of surface mount components by the insulating material.

Further, insulating materials that do not become brittle and have low shrinkage while curing are preferred.

The insulating material preferably has good adhesion to metal, ceramics and plastics.

Preferred insulating materials include: ISO-PUR K 760, Dow Corning Sylgard 170, Bectron PU4534/PH4913, Elantas PU 314/PH114, Elantas PU525MR/PH27, Elantas MC622LV/W360, Iso-Elektra ISO-PUR K760, Iso-Elektra ISO-PUR K750, Synflex Voltatex 3100, BRB Flexosil 475, Synflex Wevopur 552 FL, Stockmeier Stobicast L 781, Electrolube UR5097, Electrolube UR5633, Peters VU4452, Huntsmann Arathane CW5650, Huntsmann Arathane CW5620, Huntsmann Arathane CW5631, Araldite ® CW 2243-2 L, and Dow Corning Sylgaard 170.

In some power converters, the insulating material is ISO-PUR K 760,

ISO-PUR K 760 is a minerally filled cold-curing 2-component polyurethane cast resin based on polyether- and -esterpolyols and precured aromatic diisocyanates. The insulating material has been tested according to the German norm VDE 0291 / part 2 including hydrolysis and hydrophobic resistance. ISO-PUR K 760 is a standard material for casting electronic parts. Cured samples of ISO-PUR K 760 do not become brittle. The system has a good thermal conductivity and minimum shrinkage while curing. ISO-PUR K 760 protects against corrosion and shows good adhesion to metal, ceramics and many plastics. The standard mixing ratio resin to hardener is 4 : 1 by weight but by varying the mixing ratio different hardnesses can be achieved.

For conducting surfaces embedded in the insulating material, clearance and creepage requirements are reduced due to the higher than air dielectric strength of the insulating material, whereby the electrical circuit assembly can be made more compact without experiencing electrical breakdown or partial discharges.

Furthermore, a more compact circuit layout also leads to reduced parasitic inductances, thereby improving the functionality and performance of the circuit, as well as reducing antenna capabilities of the electrical circuit assembly so that its EMC properties are improved.

The utilization of insulating material in the power converter with the mechanical assembly is especially advantageous at high operating frequencies and even more advantageous in power converters with galvanic isolation between its primary and secondary side.

### BRIEF DESCRIPTION OF THE DRAWINGS

Below, the new power converter is explained in more detail with reference to the drawings in which various examples of the new power converter are shown. In the drawings:
- Fig. 1: schematically shows in perspective a power converter with one mechanical assembly,
- Fig. 2: schematically shows in cross-section the power converter of Fig. 1,
- Fig. 3: schematically shows in perspective a power converter with two mechanical assemblies,
- Fig. 4: schematically shows in cross-section the power converter of Fig. 3,
- Fig. 5: schematically shows in perspective a power converter with two mechanical assemblies mounted on opposite sides of a printed circuit board,
- Fig. 6: schematically shows in cross-section the power converter of Fig. 5,
- Fig. 7: schematically shows in cross-section another configuration of the power converter of Fig. 5,
- Fig. 8: schematically shows in cross-section yet another configuration of the power converter of Fig. 5,
- Fig. 9: schematically shows in perspective a power converter with one mechanical assembly of irregular shape,
- Fig. 10: schematically shows in perspective a partly potted power converter with one mechanical assembly, and
- Fig. 11: schematically shows in perspective a power converter with one mechanical assembly filled with insulating material.

### DETAILED DESCRIPTION OF EMBODIMENTS

Various illustrative examples of the new power converter according to the appended claims will now be described more fully hereinafter with reference to the accompanying drawings, in which various embodiments of the new power converter are illustrated. The new power converter according to the appended claims may, however, be embodied in different forms and should not be construed as limited to the embodiments set forth herein. In addition, an illustrated embodiment needs not have all the aspects or advantages shown. An aspect or an advantage described in conjunction with a particular embodiment is not necessarily limited to that embodiment and can be practiced in any other examples even if not so illustrated, or if not so explicitly described. It should also be noted that the accompanying drawings are schematic and simplified for clarity, and they merely show details which are essential to the understanding of the new power converter, while other details have been left out.

Like reference numerals refer to like elements throughout. Like elements may, thus, not be described in detail with respect to the description of each figure.

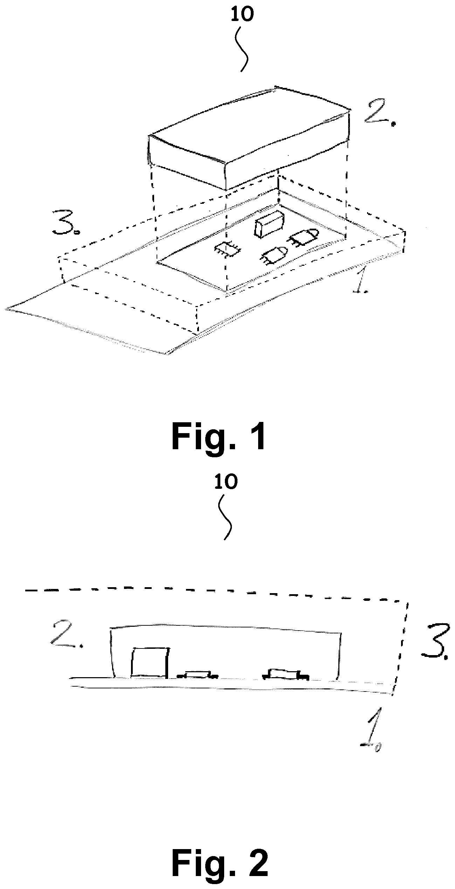

Fig. 1 shows a new power converter 10 having a housing (not shown) for accommodation of an electrical circuit assembly 1 that is adapted for converting an input voltage to an output voltage, a first mechanical assembly 2 for suppression of electromagnetic interference, in the illustrated power converter 10 for suppression of radiation emitted by the electrical circuit assembly 1. For illustration purposes, the mechanical assembly 2 is shown separated from the electrical circuit assembly 1 so that components of the electrical circuit assembly 1 is made visible. The illustrated power converter 10 has an insulating material 3 covering the electrical circuit assembly 1 and the first mechanical assembly 2. The insulating material 3 reduces required clearance and creepage distances between respective first and second conductors for improved electromagnetic compatibility (EMC).

The power converter 10 shown in Fig. 1 is also shown in cross-section in Fig. 2.

In the converter power 10 shown in Fig. 1, all parts of the electrical circuit assembly 1 except connectors are covered by the insulating material 3.

Typically, the power converter 10 shown in Fig. 1 has an operating frequency above 5 MHz.

The electrical circuit assembly 1 of the power converter 10 shown in Fig. 1, has a primary side supplied by the input voltage connected to the input and a secondary side supplying the output voltage at the output, and the first mechanical assembly 2 is connected to ground, i.e. the zero-voltage reference, of the primary side.

In another new power converter, the mechanical assembly 2 may be connected to ground of the secondary side. This can be desirable, e.g. when the ground of the secondary side is connected to a larger conductive mass than the primary side; and/or, if the size of the circuitry of the secondary side is larger than the size of the circuitry of the primary side because the mechanical assembly 2 then introduces clearance and creepage distance requirements in a smaller area, namely the area of the mechanical assembly proximate conductive parts of the smaller circuitry of the primary side.

In power electronics and electric circuit assemblies in general, minimum clearance and creepage distances between the electrical components, component terminals, wires, tracks on a printed circuit board (PCB) and all other conductive parts of the circuit, are required in order to avoid electrical breakdown (sparks) or partial discharges. The distance requirements primarily depends on the voltage potential, between the different parts, but also on the circuit and component layout, as the electrical fields are enhanced by certain shapes and layout, such as sharp edges, corners, etc. Operating frequencies of the various components also influence the distance requirements.

Power electronics and electric circuit assemblies in general also have to fulfil requirements on electromagnetic compatibility (EMC), which limit the amount of electromagnetic radiation the unit with the electrical circuit assembly is allowed to emit or radiate to the surroundings and also limit the susceptibility of the electrical circuit assembly to electromagnetic radiation received from the surroundings.

In classical power converters the operating frequency is typically below 500 kHz and in this frequency range, electronic circuit assemblies typically do not violate EMC requirements due to the physical size of the electronic circuit assembly (< 100 - 400 mm) and the wavelength of electromagnetic waves at these frequencies (at 500 kHz, the wavelength is 600 m).

Simplified, the electrical circuit assembly constitutes a very bad antenna, due to the very large difference in size of the electrical circuit assembly and wavelengths. At frequencies above 1 MHz, the size of the circuit and wavelength are of the same order of magnitude, and the electrical circuit assembly has better transmission capabilities, although the wavelength is still quite large (at 5MHz the wavelength is 60m). It should be observed that higher order harmonics of the fundamental frequency have wavelength magnitudes of the order of the size of the electrical circuit assembly. Although, the electrical circuit assembly still constitutes an ineffective antenna, the electrical circuit assembly typically requires some electromagnetic shielding in order to limit the radiated electromagnetic waves to fulfil EMC requirements, e.g. for CE approval.

However, presence of a mechanical assembly that is made of a conductive material and typically connected to a constant electrical voltage, such as a ground, of the electrical circuit assembly, increases the size of the electrical circuit assembly, because clearance and creepage distance requirements have to be fulfilled along the entire surface of the mechanical assembly and its connections to the electrical circuit assembly, instead of just between the circuit components and connections (wires) without the mechanical assembly.

For example, in an electrical circuit assembly with galvanically isolated primary side and secondary side, the clearance and creepage distance requirements dictate a large distance between the mechanical assembly and certain components of the electrical circuit assembly, e.g. if the mechanical assembly is connected to ground of the primary side of the electrical circuit assembly, a distance of, e.g., 5 - 8 mm must exist between the mechanical assembly and conductive surfaces of the secondary side of the electrical circuit assembly.

In traditional power converters, the galvanic isolation is typically provided along a single linear boundary between two galvanically isolated first and second parts of the electrical circuit assembly so that the area, in which the large clearance and creepage distances have to be obtained, is small.

The electrical circuit assembly 1 shown in Fig. 1, may have a primary side supplied by the input voltage and a secondary side supplying the output voltage, wherein the primary side is galvanically separated from the secondary side, and the first mechanical assembly may be connected to ground of one of the primary side and the secondary side.

In Fig. 1, for illustration purposes, the mechanical assembly 2 is shown in an exploded view above the electrical circuit assembly 1, however in operation, the mechanical assembly is mechanically and electrically connected to the PCB of the electrical circuit assembly 1, e.g. in a well-known way, such as by soldering, pressing, clipping onto pre-soldered taps, etc., and covers and electromagnetically shields both primary and secondary sides of the electrical circuit assembly 1 including the boundary of galvanic isolation between the two circuits as shown in Fig. 2.

Presence of the conductive mechanical assembly 2 extends the area in which the clearance and creepage distance requirements have to be fulfilled from the actual boarder line between the two circuits to anywhere along the surface of the mechanical assembly 2, thereby necessarily increasing the size of the power converter with the electrical circuit assembly and the mechanical assembly; however, the power converter 10 shown in Fig. 1 also contains an insulating material 3 with a high dielectric strength so that the clearance and creepage distance requirements are lowered, e.g. from 8 mm to 1.2 mm, so that the addition of the mechanical assembly, provided that the insulating material 3 is added, after all does not increase the size of the power converter 10.

In the event that the primary side supplied with the input voltage and the secondary side supplying the output voltage of the electrical circuit assembly 1 are not galvanically separated, design requirements to clearance and creepage distances are reduced but still present. Thus, the resulting increase in size of the power converter when adding the mechanical assembly is smaller than for a converter with galvanic separation; however, it is still an advantage to introduce the insulating material 3 to avoid any size increase.

The mechanical assembly 2 of the power converter shown in Fig. 1, has a plurality of holes (not shown) to allow air and air bubbles to pass through the mechanical assembly during insulating.

The power converter 10 shown in Fig. 1 may further comprise a heat sink (not shown) mounted to the mechanical assembly 2 for improved heat dissipation.

The insulating material 3 has a high dielectric strength that is at least higher than the dielectric strength of air to provide improved insulation of conducting surfaces covered or embedded in the insulating material 3.

Preferably, the insulating material 3 also has good thermal conductivity so that the insulating material 3 is capable of transmitting heat generated by components covered by or embedded in the insulating material 3 away and towards the surroundings.

For electrical circuit assemblies of the new power converters, insulating materials 3 with low glass transition temperature T_{g}, which is the temperature at which the insulating material changes structure, similar to a crystalline structure change, and becomes harder and more brittle, e.g. urethane and silicone based insulating materials, are preferred to avoid breaking of the solder connections of the surface mount components by the insulating material.

Further, insulating materials 3 that do not become brittle and have low shrinkage while curing are preferred.

The insulating material 3 preferably has good adhesion to metal, ceramics and plastics.

In the new power converter 10 shown in Fig. 1, the insulating material 3 is ISO-PUR K 760,

For conducting surfaces covered by or embedded in the insulating material 3, clearance and creepage distance requirements are reduced due to the higher than air dielectric strength of the insulating material 3.

Thus, with the insulating material 3, the power converter 10 can be made much more compact without experiencing electrical breakdown or partial discharges. Advantages of a more compact circuit layout includes reduced parasitic inductances, thereby improving the functionality and performance of the circuit as well as deteriorating undesired antenna properties of the electrical circuit assembly 1 so that EMC properties are improved.

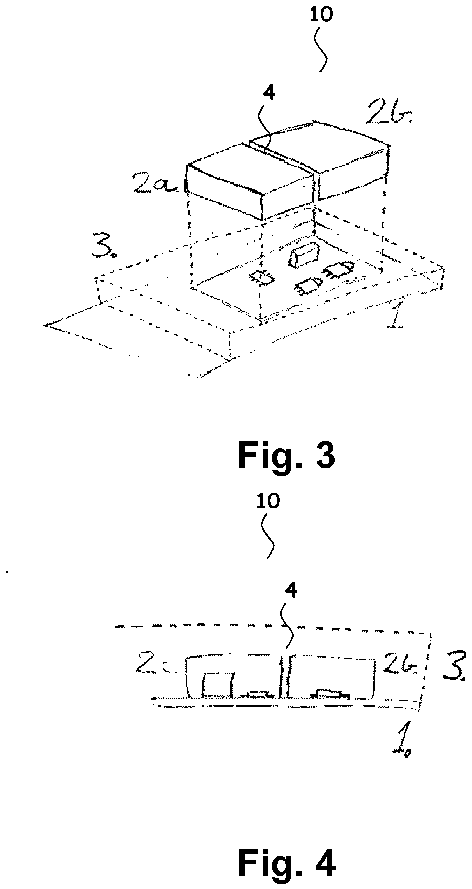

Figs. 3 and 4 show another power converter 10 with two mechanical assemblies 2a, 2b, namely a first mechanical assembly 2a and a second mechanical assembly 2b. The power converter 10 shown in Figs. 3 and 4 has the same parts and components as the power converter 10 shown in Figs. 1 and 2 except for the fact that the power converter 10 shown in Figs. 3 and 4 has two mechanical assemblies 2a, 2b whereas the power converter 10 shown in Figs. 1 and 2 has only a single mechanical assembly 2.

In the power converter 10 shown in Figs. 3 and 4, the first mechanical assembly 2a is connected to ground of the primary side of the electrical circuit assembly 1 and the second mechanical assembly 2b is connected to ground of the secondary side of the electrical circuit assembly 1.

As in Figs. 1 and 2, all parts of the electrical circuit assembly 1 except connectors are covered by or embedded in the insulating material 3 in Figs. 3 and 4.

A slot 4 formed between the first mechanical assembly 2a and the second mechanical assembly 2b accommodates part of the insulating material 3 so that the slot is allowed to be narrower than without the insulating material 3.

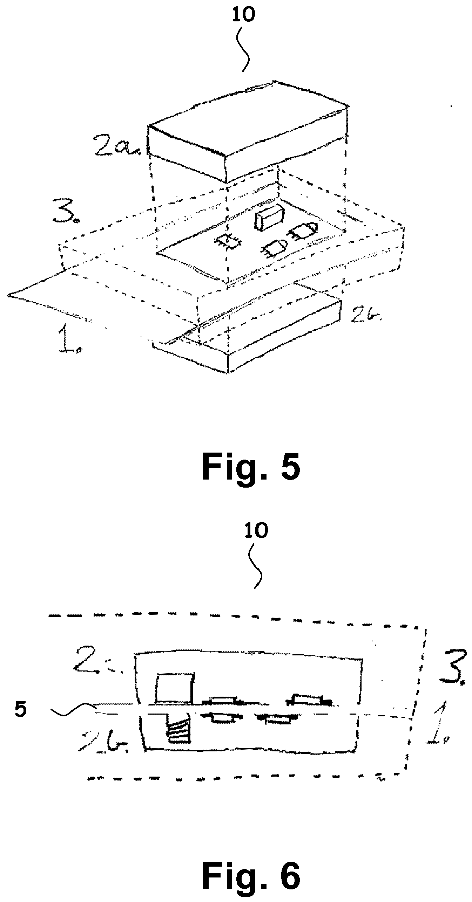

Figs. 5 and 6 show another power converter 10 with two mechanical assemblies 2a, 2b, namely a first mechanical assembly 2a and a second mechanical assembly 2b, mounted on opposite sides of the electrical circuit assembly 1.

The power converter 10 shown in Figs. 5 and 6 has the same parts and components as the power converter 10 shown in Figs. 3 and 4 and are similar except for the different mounting of the two mechanical assemblies 2a, 2b.

In the power converter shown in Figs. 5 and 6, the first mechanical assembly 2a is connected to ground of the primary side of the electrical circuit assembly 1 and the second mechanical assembly 2b is connected to ground of the secondary side of the electrical circuit assembly 1.

As in Figs. 1 - 4, all parts of the electrical circuit assembly 1 except connectors are covered by or embedded in the insulating material 3 in Figs. 5 and 6.

It should be noted that in the power converter 10 shown in Figs. 5 and 6, the PCB 5 of the electrical circuit assembly 1 provides required clearance distances between circuitry on opposite sides of the PCB.

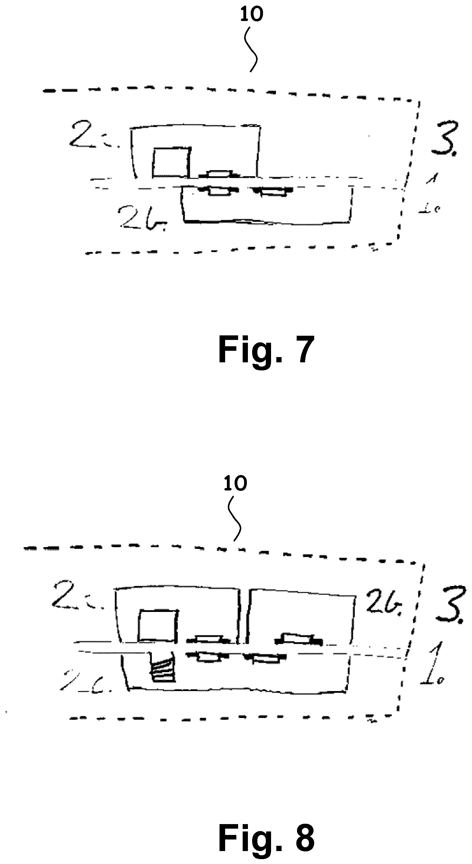

Fig. 7 shows another power converter 10 with two mechanical assemblies 2a, 2b, namely a first mechanical assembly 2a and a second mechanical assembly 2b, mounted on opposite sides of the electrical circuit assembly 1; however, displaced with relation to each other.

The power converter 10 shown in Fig. 7 is similar to and has the same parts and components as the power converter 10 shown in Figs. 5 and 6 except for the different mounting of the two mechanical assemblies 2a, 2b.

Fig. 8 shows another power converter 10 with three mechanical assemblies 2a, 2b, and 2c.

The power converter 10 shown in Fig. 8 has the same parts and components as the power converter 10 shown in Figs. 5 and 6 except for the fact that the power converter 10 shown in Fig. 8 has three mechanical assemblies 2a, 2b, 2c whereas the power converter 10 shown in Figs. 5 and 6 has only two mechanical assemblies 2a, 2b.

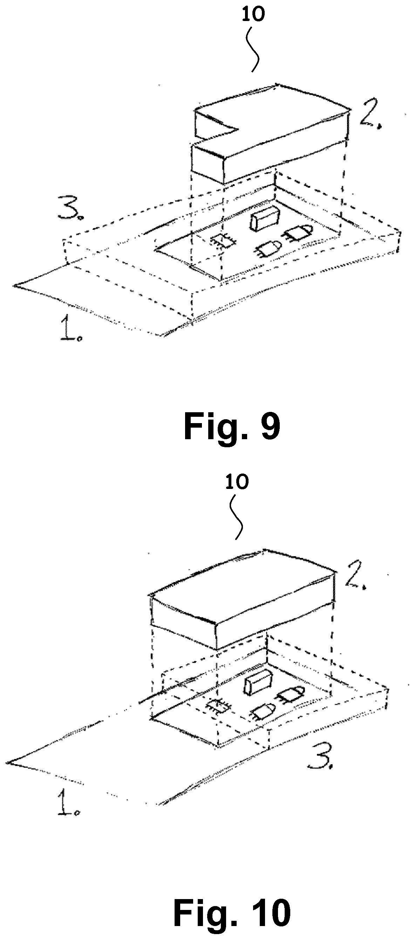

Fig. 9 shows another power converter 10 with a single mechanical assembly 2 having an irregular shape. Apart from the irregular shape of the mechanical assembly 2, the power converter 10 shown in Fig. 9 is similar to and has the same parts and components as the power converter 10 shown in Fig. 1, having a mechanical assembly 2 of a regular rectangular shape.

Fig. 10 shows another power converter 10 with a single mechanical assembly 2 with a regular rectangular shape and with insulating material 3 only partly covering the electrical circuit assembly 1.

In the power converter 10 shown in Fig. 10, a selected first part of the electrical circuit assembly 1 is covered with the insulating material 3 and a selected second part of the electrical circuit assembly 1 is not covered by the insulating material 3. In this way increased heat transfer to heat sensitive components, such as electrolyte capacitors, in the second part of the electrical circuit assembly 1 can be avoided.

Apart from the partial covering by the insulating material 3, the power converter 10 shown in Fig. 10 is similar to and has the same parts and components as the power converter 10 shown in Fig. 1, in which all parts of the electrical circuit assembly 1 except connectors are covered by the insulating material.

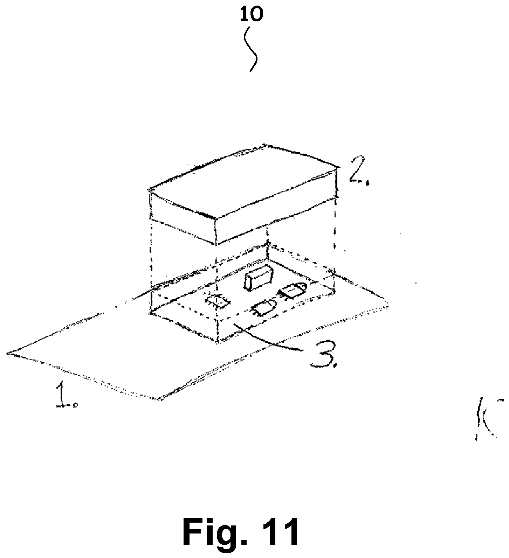

Fig. 11 shows another power converter 10 with a single mechanical assembly 2 with a regular rectangular shape and with insulating material 3 only partly covering the electrical circuit assembly 1.

In the power converter 10 shown in Fig. 11, only the part of the electrical circuit assembly 1 covered with the mechanical assembly 2, is covered with the insulating material 3 while the remaining part of the electrical circuit assembly 1 is not covered by the insulating material 3.

Apart from the partial covering by the insulating material 3, the power converter 10 shown in Fig. 11 is similar to and has the same parts and components as the power converter 10 shown in Fig. 1, in which all parts of the electrical circuit assembly 1 except connectors are covered by the insulating material.

## Claims

1. A power converter comprising
an electrical circuit assembly,
a first mechanical assembly that is mounted to the electrical circuit assembly for suppression of electromagnetic interference, and
an insulating material between first and second conductors of the power converter for reducing required clearance and creepage distances between the respective first and second conductors.

2. A power converter according to claim 1, having an input and an output, and wherein the input is galvanically separated from the output.

3. A power converter according to claim 1 or 2, wherein a selected first part of the electrical circuit assembly is covered with the insulating material and a selected second part of the electrical circuit assembly is not covered with the insulating material.

4. A power converter according to claim 3, wherein the selected first part of the electrical circuit assembly includes the part of the electrical circuit assembly covered by the first mechanical assembly and the selected second part of the electrical circuit assembly includes the remaining part of the electrical circuit assembly.

5. A power converter according to claim 1 or 2, wherein all parts of the electrical circuit assembly except connectors are covered by the insulating material.

6. A power converter according to any of the previous claims, wherein the power converter has an operating frequency above 5 MHz.

7. A power converter according to any of the previous claims, wherein the first mechanical assembly is at a voltage potential with a reference to one of the input and the output.

8. A power converter according to any of the previous claims, wherein the first mechanical assembly is at a zero-voltage potential of one of the input and the output.

9. A power converter according to any of the previous claims, comprising a second mechanical assembly that is mounted to the electrical circuit assembly for suppression of electromagnetic interference, and wherein a space formed between the first mechanical assembly and the second mechanical assembly accommodates part of the insulating material.

10. A power converter according to claim 9, wherein the first mechanical assembly is mounted to the electrical circuit assembly on one component side of a printed circuit board of the electrical circuit assembly and the second mechanical assembly is mounted to the electrical circuit assembly on an opposite component side of the printed circuit board.

11. A power converter according to any of the previous claims, wherein the mechanical assembly has a plurality of holes.

12. A power converter according to any of the previous claims, comprising a heat sink mounted to the mechanical assembly.

13. A power converter according to any of the previous claims, wherein the insulating material is selected from the group consisting of: ISO-PUR K 760, Dow Corning Sylgard 170, Bectron PU4534/PH4913, Elantas PU 314/PH114, Elantas PU525MR/PH27, Elantas MC622LV/W360, Iso-Elektra ISO-PUR K760, Iso-Elektra ISO-PUR K750, Synflex Voltatex 3100, BRB Flexosil 475, Synflex Wevopur 552 FL, Stockmeier Stobicast L 781, Electrolube UR5097, Electrolube UR5633, Peters VU4452, Huntsmann Arathane CW5650, Huntsmann Arathane CW5620, Huntsmann Arathane CW5631, Araldite ® CW 2243-2 L, and Dow Corning Sylgaard 170.

14. A power converter according to any of the previous claims, wherein at least one of the first and second mechanical structure is connected to a conductor of a printed circuit board of the electrical circuit assembly, whereby the interconnected at least one of the first and second mechanical structure and the conductor forms an enclosure for suppression of electromagnetic interference.

15. A power converter according to any of the previous claims, wherein the first mechanical structure is made of metal.
